# EUROPÄISCHE PATENTSCHRIFT

(11) **EP 2 670 721 B1**
(45) Veröffentlichungstag und Bekanntmachung des Hinweises auf die Patenterteilung: **22.08.2018**
(21) Anmeldenummer: 12703765.3
(22) Anmeldetag: 03.02.2012
(51) Int. Cl.: C01G 33/00, C01G 35/00, H01L 41/43, C01B 33/00, C01F 7/00, C04B 35/495, C04B 35/626, H01L 41/187

(54) **VERFAHREN ZUM HERSTELLEN EINES PHASENREINEN MEHRSTOFFSYSTEMS UND KERAMIKWERKSTOFF AUF BASIS DES PHASENREINEN MEHRSTOFFSYSTEMS**
PROCESS OF MANUFACTURE OF A PHASE-PURE MULTI-SYSTEM CERAMIC MATERIAL AND CERAMIC MATERIAL ON THE BASIS OF A PHASE-PURE MULTI-SYSTEM
PROCEDÉ DE FABRICATION D'UNE MATIERE DE PHASE PURE MULTI-SYSTÈME CÉRAMIQUE ET UN MATÉRIAU CÉRAMIQUE SUR LA BASE D'UNE PHASE-PURE MULTI-SYSTEME

(30) Priorität: 04.02.2011 DE 102011010346
(43) Veröffentlichungstag der Anmeldung: 11.12.2013
(73) Patentinhaber: H.C. Starck Tantalum and Niobium GmbH, 80339 München (DE)
(72) Erfinder: BECK, Karsten, 90482 Nürnberg (DE); ALBRECHT, Sven, Goslar 38642 (DE); SCHNITTER, Christoph, Holle 31188 (DE); LANGETEPE, Timo, 2584ET Den Haag (NL); OTTERSTEDT, Ralph, Goslar 38640 (DE)
(86) Internationale Anmeldenummer: PCT/EP2012/051899
(87) Internationale Veröffentlichungsnummer: WO 2012/104430

(56) Entgegenhaltungen:
- WO-A1-2005/028367
- JP-A- 2009 242 230

## Beschreibung

Die Erfindung betrifft ein Verfahren zum Herstellen eines homogenen Mehrstoffsystems auf Hydroxid- und /oder Oxidbasis, insbesondere eines homogenen Mehrstoffsystems mit einer stäbchenförmigen Morphologie (genannt auch Form), wobei das Mehrstoffsystem ein erstes Element aus der Gruppe Ti, Zr, Hf, V, Nb, Cr, Mo, W, Re, Sb, Si, Al und Ta und ein zweites Element aus der Gruppe Ti, Zr, Hf, V, Nb, Cr, Mo, W, Re, Sb, Si, Al und Ta aufweist, wobei das erste und/oder das zweite Element insbesondere als Fluorokomplex, insbesondere H₂NbF₇, H₂TaF₇, HSbF₆, H₂ZrF₆, H₂SiF₆, H₃AlF₆ oder dergleichen, vorliegt. Weiterhin betrifft die Erfindung einen Keramikwerkstoff und einen Formkörper aus dem Keramikwerkstoff sowie ein zugehöriger Verbundkörper.

Keramische Mischmaterialien werden meist aus entsprechenden Oxiden und Carbonaten hergestellt, indem diese intensiv in Kugelmühlen gemahlen, vermischt und anschließend bei hohen Temperaturen kalziniert werden. Diese Verfahren erfordern jedoch das Anfertigen einer heterogenen Mischung, die durch den Kalzinationsschritt nur unvollständig zu einer homogenen Phase reagiert.

Die heutigen Hochleistungskeramiken benötigen eine möglichst einheitliche Elementverteilung ohne lokale Anreicherung der Hauptkomponenten und Dotierungsmittel.

Immer mehr Anwendungen verwenden piezoelektrische oder entsprechende ferroelektrische Eigenschaften keramischer Materialien. So werden Entfernungsmesser, Ultraschallwandler, Ink-Jet-Düsen, Common-Rail-Diesel-Injektoren aus Hochleistungskeramiken hergestellt. Dabei werden heutzutage Keramiken verwendet, welche auf Basis von Bleizirkontitanat (PZT) und Dotierstoffen hergestellt werden.

Da die Umweltfreundlichkeit solcher Aktoren und Resonatoren immer wichtiger wird, gibt es Bestrebungen gesundheits- und umweltschädliche Komponenten in diesen elektrischen Systemen zu eliminieren.

Ein alternatives Materialsystem mit piezoelektrischen Eigenschaften basiert auf Natrium-Kaliumniobat. Die piezoelektrischen Eigenschaften keramischer Bauteile aus diesem Materialsystem hängen, neben typischerweise für die Keramikherstellung wichtigen Pulvereigenschaften wie Partikelgröße oder entsprechend Partikelgrößenverteilung, chemischer Reinheit, Sinteraktivität, Schrumpfung usw., besonders von der Dichte, Phasenreinheit und/oder chemischer Homogenität und möglichst vollständiger Ausrichtung aller ferro- und/oder piezoelektrischen Domänen der Keramikkörner in eine äußere Vorzugsrichtung ab. Diese vollständige Ausrichtbarkeit der Domänen wird insbesondere durch die definierte Orientierung möglichst vieler Körner zu einem äußeren elektrischen Feld erreicht. Dabei bewirkt das elektrische Feld eine Polarisation.

Eine solche Orientierung der Körner zum elektrischen Feld wird durch die Ausrichtung geeigneter plättchenförmiger und/oder delförmiger Einkristalle beim Foliengießen und anschließendem hetero- oder homoepitakttischen Aufwachsen der gewünschten (pseudo-)kubischen Phase aus dem Natrium-Kaliumniobat-Materialsystem erreicht.

Geeignete plättchen- oder entsprechende nadelförmige Kristallite bilden die Voraussetzung für die Ausrichtbarkeit der Körner in der Keramik oder der entsprechenden ferroelektrischen Domänen in diesen Körnern. Diese Kristallite sind durch aufwendige Zucht von Einkristallen oder durch gezieltes Herstellen während der Synthese des keramischen Pulvers erhältlich.

Im Stand der Technik werden diese Keramiken zur Herstellung piezoelektrischer Bauteile eingesetzt. Insbesondere sind diese Bauteile in der Mechatronic ein wichtiges Element. Besonders für leistungsstarke und emissionsarme Dieselmotoren werden solche Bauteile in den Dieseleinspritzaggregaten eingesetzt. Die Anforderungen an solche mehrschichtigen Körper aus piezoelektrischen Keramiken sind enorm hoch.

Die Schalthübe werden immer größer und müssen schneller geschaltet erfolgen, wobei die Funktion auch bei den extremen Umgebungsbedingungen im Motor zu gewährleisteten ist.

Die schlechte Recyclebarkeit dieser Bauteile und der giftige Einsatzstoff Blei führte zur Suche von piezoelektrischen Materialien, welche ähnliche oder bessere technische Eigenschaften als PZT aufweisen. Eine technische Eigenschaft ist der piezoelektrische Koeffizient d₃₃, welcher in der Einheit pm/V angegeben wird. Dieser piezoelektrische Koeffizient ist ein Maß für die Längenausdehnung pro Volt Spannung über einer metallisierten und gepolten Keramikprobe im Kleinsignalbereich in Richtung des angelegten Feldes.

Im Jahr 2004 veröffentlichte der Automobilhersteller Toyota zusammen mit dem Zulieferer Denso in der Zeitschrift Nature unter dem Titel "Lead free piezoceramics", Bd. 432 (2004), S. 84-87 eine Zusammensetzung für eine piezoelektrische Keramik, welche mit dem heutigen Hochleistungs-PZTs (Pb(ZrₓTi₁₋ₓ)O₃) vergleichbare Eigenschaften aufweist.

Dieses Material besteht aus komplexen Perowskiten AA'BB'O₃ mit im Wesentlichen Kalium und Natrium auf dem A-Platz und Niob und Tantal auf dem B-Platz. Auf dem A-Platz ist des Weiteren Li und auf dem B-Platz Sb hinzudotiert. Ferner ist die Phase durch ein kompliziertes Templateverfahren plättchenförmig ausgestaltet. Dies bedeutet, dass eine spezielle morphologische Orientierung vorliegt, wodurch der piezoelektrische Koeffizient d₃₃ von ca. 250 pm/V auf den mit PZT vergleichbaren Wert von 400pm/V angehoben wurde. Die Herstellung der Verbindung erfolgte aus unterschiedlichen Oxiden (Nb₂O₅, Ta₂O₅) und Carbonaten (K₂CO₃, Na₂CO₃). Dieses Verfahren ist unter anderem in den Patenten EP 138 2 588 und DE 102 005 027 928 und in dem Aufsatz "Lead free piezoceramics" in Nature 432 (2004) 84-87 beschrieben.

Die unzureichende Mischbarkeit der patentierten Niob- und Tantalverbindungen in der Mixed-Oxide-Methode von Toyota und Denso wird in dem Artikel Mater. Lett. 59 (2005), 241-244 von Yiping Guo beschrieben.

Für reines Kalium- bzw. Natriumniobat existieren ältere Herstellungsverfahren, wobei die Partikel keine gesonderte Partikelform aufweisen. In der russischen Zeitschrift lzv. Vysshikh Uchebn. Zavedenii Tsvetn. Met. (Nonferrous Metallurgy), 5 (1963), S. 99-107 beschreibt Zelikman die Umsetzung von Kaliumhydroxid mit Niobhydroxid im Autoklaven bei 150°C - 200°C unter Druck zu einer löslichen Kaliumverbindung (K₈Nb₆O₁₉), welche durch Kalzination über 400°C oder bei hohen KOH Konzentrationen zu reinem Kaliumniobat zerfällt. Auf dieses Zitat verweist auch Gmelins Handbuch der anorganischen Chemie, Niob, Teil B4, 8 Auflage, 1973, S. 157.

Durch die Verwendung eines Autoklaven und der hohen Temperaturen für dieses Verfahren entstehen hohe Kosten.

Bei der Gewinnung von Niob und Tantal aus Erzen und Erzkonzentraten sind Verfahren bekannt, in denen Niob- und Tantaloxide mittels konzentrierter Laugen ausgewaschen werden (z.B. Hydrometallurgy 80, (2005), S. 126-131; CN1238536; JP8041559).

Ähnliche Verfahren werden bei der hydrothermalen Synthese von Kalium- und Natriumniobaten verwendet, bei denen Nioboxid im Autoklaven mit Alkalihydroxiden aufgeschlossen wird, C.H. Lu, Mater. Lett.34 (1998) 172-176).

Ein weiteres Verfahren beruht auf der Hydrolyse von Niob- und Tantaloxiden. Dies ist u.a. in dem Patent DE 125 7 125 der Firma CIBA beschrieben. Weiterführende Artikel sind "microemulsion mediated synthesis of nanocrystalline (KxNa1-x)NBO3 powders", J. Crystal Growth, 280 (2005)191-200, in dem Öl-Wasser-Emulsionen zur Kontrolle der Partikelgröße eingesetzt werden.

Um lösliche Verbindungen zu erhalten, können auch Komplexe der Niob- und Tantaloxide eingesetzt werden. Dabei spielen Tartrate und Peroxotartrate eine vorherrschende Rolle unter den Carboxylsäuren. Diese Komplexe werden anschließend bei hohen Temperaturen zu den Zielverbindungen (Niobaten) zersetzt. Beispiele hierfür sind in M. Devillers, Inorg. Chem. 44, (2005), S. 1554-1562 oder B. Malic, J. Eur. Ceram. Soc. 25, (2005), S. 2707-2711 zu finden.

Auch bei der Verwendung von Natrium-Kaliumniobat (später auch NKN genannt) als Materialsystem für piezoelektrische Bauteile hängen die piezoelektrischen Parameter von Partikelgröße, Reinheit, Sinteraktivität, Schrumpfung und dergleichen sowie der Homogenität ab. Eine höhere Homogenität wird durch höhere Kalzinationstemperaturen erreicht. Dies führt bei NKN jedoch zum Abdampfen des leicht flüchtigen Kaliumoxids.

JP 2009242230 A offenbart die Herstellung eines stabilen Alkaliniobat Perowskitkristalls mit gleichförmigem Aufbau.

WO 2005/028367 A1 offenbart ein Verfahren zur Herstellung eines Ventilmetalloxidpulvers durch Umsetzung einer fluoridhaltigen Ventilmetallverbindung mit einer Base in Gegenwart von Wasser und Kalzination des dabei entstehenden Produkts, wobei die Umsetzung bei einer Temperatur von mindestens 45°C erfolgt.Aufgabe der Erfindung ist es den Stand der Technik zu verbessern.

In einem Aspekt der Erfindung wird die Aufgabe gelöst durch ein Verfahren zum Herstellen eines homogenen Mehrstoffsystems auf Hydroxid- und /oder Oxidbasis, insbesondere eines homogenen Mehrstoffsystems mit einer stäbchenförmiger Morphologie (Form), wobei das Mehrstoffsystem ein erstes Element aus der Gruppe Mo, W, Nb, Re, Zr, Hf, V, Sb, Si, Al und Ta und ein zweites Element aus der Gruppe Mo, W, Nb, Re, Zr, Hf, V, Sb, Si, Al und Ta aufweist und wobei das erste Element und das zweite Element unterschiedlich sind, wobei das erste oder das zweite Element, oder das erste und das zweite Element als Fluor- oder Oxifluorkomplex, oder als Fluor- und Oxifluorkomplex vorliegt, wobei in der ersten Alternative das erste Element in einer ersten flusssauren Lösung und das zweite Element in einer zweiten flusssauren Lösung vorliegen und die erste flusssaure Lösung mit dem ersten Element und die zweite flusssaure Lösung mit dem zweiten Element gemischt wird, sodass eine flusssaure Mischlösung mit gelöstem ersten und zweiten Element vorliegt, oder in einer zweiten Alternative das erste Element und das zweite Element in einer alternativen flusssauren Mischlösung gelöst sind und abschließend die flusssaure Mischlösung oder die alternative flusssaure Mischlösung mit einem Fällungsmittel gefällt wird, sodass ein Feststoffgemisch in einer Suspension vorliegt, wobei das Fällungsmittel eine basische Lösung, eines basisch wirkenden Feststoffs oder eines basischen wirkenden Gases ist und das Fällen bei einem pH-Wert zwischen 6.5 und 14 der flusssauren Mischlösung oder der alternativen flusssauren Mischlösung erfolgt.

Dadurch kann eine Suspension mit einem homogenen Feststoffgemisch bereitgestellt werden.

In einem weiteren Aspekt der Erfindung wird die Aufgabe gelöst durch die Bereitstellung eines Keramikwerkstoffs, insbesondere in Form von Pulver oder Pasten, dadurch gekennzeichnet, dass der Keramikwerkstoff nach dem erfindungsgemäßen Verfahren erhalten wird.

In einem weiteren Aspekt der Erfindung wird die Aufgabe gelöst durch ein Verfahren zur Herstellung des erfindungsgemäßen Formkörpers dadurch gekennzeichnet, dass der Formkörper aus dem erfindungsgemäßen Keramikwerkstoff durch uniaxiales oder kaltisostatisches Pressen, Foliengießen mit gegebenenfalls anschließendem Stapeln und/oder Siebdrucken von grünen Kontaktschichten, PIMs (Power injection moulding), Nasspulverspritzen, Schlickergießen oder Sintern erhalten wird.

In einem weiteren Aspekt der Erfindung wird die Aufgabe gelöst durch die Verwendung eines erfindungsgemäßen Formkörpers erhältlich nach dem erfindungsgemäßen Verfahren zur Herstellung des erfindungsgemäßen Verbundkörpers, insbesondere eines Piezo-Elements wie es in Entfernungsmessern, Ultraschallwandlern, Ink-Jet-Düsen, Common-Rail-Diesel-Injektoren verwendet wird.Als "homogen" wird ein Mehrstoffsystem insbesondere dann bezeichnet, wenn in dem zugehörigen Röntgenspektrum keine oder nur eine geringe Phasentrennung zu erkennen ist. Von einer geringen Phasentrennung wird dann ausgegangen, wenn die Signale der Fremd- oder Reinstphasen nur in geringem Umfang vorhanden sind. Dies ist dann gegeben, wenn die Signale im Rauschen des Analysensignals untergehen (nicht sichtbar sind) oder bei quantitativer Auswertung der Signalpeaks nur wenige Prozent (<5 %) ausmachen.

Ein "Mehrstoffsystem" kann wenigstens zwei Elemente aufweisen. Es können jedoch weitere Elemente und/oder Dotierelemente durch das Mehrstoffsystem umfasst sein.

Als "Hydroxid- und /oder Oxidbasis" kann ein Mehrstoffsystem bezeichnet werden, wenn die anionische Komponente der Verbindung hauptsächlich, das heißt zu einem Anteil von >85% als Oxid (O²⁻-Ion) oder Hydroxid (OH⁻-Ion) vorliegt.

Eine "stäbchenförmige Morphologie" (Form) ist insbesondere dann gegeben, wenn das Längen zu Breitenverhältnis einen Wert zwischen 3 und 10 und insbesondere 5 oder mehr aufweist.

Als "flusssaure Lösungen" werden insbesondere wässrige Lösungen verstanden, welche Fluorwasserstoff und/oder deren Ionen aufweisen.

In einer Ausführungsform der Erfindung kann der flusssauren Mischlösung oder der alternativen flusssauren Mischlösung eine dritte oder weitere flusssaure Lösung mit einem gelösten dritten oder weiteren Metall aus der Gruppe der Elemente Mo, W, Nb, Re, Zr, Hf, V und Ta vor dem Fällen zugemischt werden. Dadurch kann die herzustellende Keramik weitere Elemente aufweisen.

Dieser Vorteil kann ebenfalls dadurch erlangt werden, dass in der flusssauren Mischlösung oder der alternativen flusssauren Mischlösung ein drittes oder weiteres Element aus der Gruppe Mo, W, Nb, Re, Zr, Hf, V und Ta vor dem Fällen gelöst wird.

Um der herzustellenden Keramik besondere elektrische Eigenschaften aufzuprägen, kann ein Dotierelement aus der Gruppe Ti, Zr, Sn, Fe, Co, Ni, Ca, Zn, Pd, Cd, Al, Si, P, Ge, As, Se, Sb, Te, Sc, Y, Yb in der ersten flusssauren Lösung und/oder in der zweiten flusssauren Lösung und/oder in der flusssauren Mischlösung und/oder in der alternativen flusssauren Mischlösung und/oder in dem Fällungsmittel und/oder in einer ersten flusssauren Dotierelementlösung gelöst sein, wobei im Falle, dass das Dotierelement in der Dotierelementlösung und/oder in dem Fällungsmittel gelöst ist, die Dotierelementlösung und/oder das Fällungsmittel der ersten flusssauren Lösung, der zweiten flusssauren Lösung, der flusssauren Mischlösung oder der alternativen flusssauren Mischlösung zugegeben wird, sodass das Dotierelement wenigstens teilweise als Oxid oder Hydroxid beim Fällen ausfällt.

Ein "Dotierelement" ist insbesondere ein Element des Periodensystems der Elemente, das dem Mehrstoffsystem zugesetzt wird, um die spezifischen Eigenschaften zu ändern und eine Konzentration von weniger als 10% ausmacht und als Nebenbestandteil bezeichnet werden kann.

Als "Fällungsmittel" können alle Stoffe, Flüssigkeiten oder Materialien verstanden werden, welche den pH-Wert so verändern, dass sich in einer Umgebung Feststoffe bilden.

Gemäß der vorliegenden Erfindung ist das Fällungsmittel eine basische Lösung, ein basisch wirkender Feststoff oder ein basisch wirkendes Gas und das Fällen erfolgt bei einem pH-Wert zwischen 6,5 und 14 der flusssauren Mischlösung oder der alternativen flusssauren Mischlösung. Dabei kann der pH-Wert anfänglich während des Fällens grob mittels Indikatorpapier bestimmt werden und nachdem keine Zerstörung der pH-Elektrode zu erwarten ist mittels einer handelsüblichen Glaselektrode zur pH-Wertbestimmung, z.B. Mettler-Toledo bestimmt werden.

Um ein Produkt mit einer stäbchenförmigen Partikelmorphologie zu erhalten, kann die Fällung in zwei Stufen erfolgen, indem das Fällungsmittel zunächst nur bis zu einem pH-Wert von 12 bis 13,5, bevorzugt 12 bis 13, besonders bevorzugt 12 bis 12,5 zugegeben wird, dann für 30 bis 50 Minuten, bevorzugt für 30 bis 45 Min., besonders bevorzugt für 30 bis 40 Min. gerührt wird, und anschließend erst das restliche Fällungmittel bis zu einem pH-Wert (pH 14) zugegeben wird.

Eine stäbchenförmige Partikelmorphologie des Keramikpulvers kann in den daraus hergestellten Formkörpern eine bevorzugte Orientierung der Partikel und somit eine bessere Ausrichtung der ferroelektrischen Domänen bewirken. Dies kann den piezoelektrischen Effekt gegenüber Formkörpern aus Keramikpulvern mit irregulär geformten Partikeln signifikant erhöhen.

Eine "basische Reagenz" umfasst insbesondere eine chemische Substanz, die im wässrigen Medium den pH-Wert erhöht. Dazu können Lösungen (wie z.B. aber nicht ausschließlich Natronlauge, Kalilauge), Feststoffe (wie z.B. aber nicht ausschließlich Natriumhydroxid, Kaliumoxid, Lithiumhydroxid) oder Gase (wie z.B. aber nicht ausschließlich Ammoniak) zählen.

Um eine phasenreine Zielkeramik herzustellen, kann die basische Lösung eine erste Alkalihydroxidlösung und/oder eine erste Erdalkalihydroxidlösung oder eine erste Mischung mehrerer Alkalihydroxidlösungen und/oder eine erste Mischung mehrerer Erdalkalihydroxidlösungen oder eine erste Mischung einer oder mehrerer Alkalihydroxid-Lösungen und/oder eine erste Mischung einer/oder mehrerer Erdalkalihydroxid-Lösungen enthalten, wobei die Alkali- und/oder Erdlakalihydroxid-Lösungen mindestens ein gelöstes amphoteres Element aufweisen, wobei die erste Alkalihydroxidlösung ein erstes Alkalielement und die erste Erdalkalihydroxidlösung ein erstes Erdalkalielement und die erste Mischung mehrerer Alkalihydroxidlösungen mehrere Alkalielemente und die erste Mischung mehrerer Erdalkalihydroxidlösungen mehrere Erdalkalielemente aufweist, sodass sich eine erste Suspension mit einem ersten Zwischenprodukt ergibt, welches im Feststoffanteil ein erstes Alkalielement oder eine Mischung mehrerer Alkalielemente und/oder ein erstes Erdalkalielement oder eine Mischung von Erdalkalielementen gleichmäßig verteilt (homogen) aufweisen kann.

In einer weiteren Ausführungsform kann die erste Alkalihydroxidlösung und/oder die erste Erdalkalihydroxidlösung ein wässriges Hydroxid und/oder ein Hydroxidkomplex, insbesondere KOH, LiOH, NaOH, RbOH, Ca(OH)₂ und/oder eine Hydroxidkomplex der Elemente ausgewählt aus der Gruppe Zink, Aluminium, Antimon aufweisen. Dadurch können kostengünstige und leicht handhabbare Alkalihydroxidlösungen und Erdalkalihydroxidlösung bereitgestellt werden.

In einer weiteren Ausführungsform kann die Suspension filtriert werden, sodass das Feststoffgemisch als Suspensionsrückstand vorliegt.

Um den Suspensionsrückstand von unerwünschten Stoffen zu reinigen, kann der Suspensionsrückstand gewaschen werden.

In einer weiteren Ausführungsform können die Suspension oder der Suspensionsrückstand getrocknet werden, sodass ein getrockneter Rückstand vorliegt, wobei die Trocknung insbesondere bei Temperaturen von ≤ 150°C erfolgt. Somit können die Energie für das Trocknen reduziert und die Kosten für die Trocknung vermindert werden.

Um eine homogene Partikelverteilung zu erreichen, kann die Suspension oder der Suspensionsrückstand durchmischt werden.

In einer weiteren Ausführungsform können der Suspension, dem Suspensionsrückstand, dem getrockneten Rückstand, dem durchmischten Suspensionsrückstand und/oder der durchmischten Suspension eine basische Lösung auf wässriger und/oder organischer Basis zugegeben werden, sodass sich ein erstes Zwischenprodukt ergibt.

Um ein gleichmäßiges Fällen zu bewirken, kann die Zugabe der basischen Lösung unter Rühren erfolgen.

Um die Dotierelemente homogen in die Zielkeramik einzubringen, kann die basische Lösung eine Alkalihydroxidlösung und/oder eine Erdalkalihydroxidlösung oder eine Mischung mehrerer Alkalihydroxidlösungen und/oder eine Mischung mehrerer Erdalkalihydroxidlösungen aufweisen, wobei die Alkalihydroxidlösung ein Alkalielement und die Erdalkalihydroxidlösung ein Erdalkalielement und die Mischung mehrerer Alkalihydroxidlösungen mehrere Alkalielemente und die Mischung mehrerer Erdalkalihydroxidmischungen mehrere Erdalkalielemente aufweisen, sodass sich ein zweites Zwischenprodukt ergibt, welches ein Alkalielement oder eine Mischung mehrerer Alkalielemente und/oder ein Erdalkalielement oder eine Mischung von Erdalkalielementen gleichmäßig verteilt aufweist.

In einer weiteren Ausführungsform kann das Zugeben der basischen Lösung bei Temperaturen zwischen 0°C und 40°C, bevorzugt bei Raumtemperatur und einem Druck zwischen 800 mbar und 1200 mbar, bevorzugt bei Normaldruck, erfolgen. So kann das Verfahren bei üblichen Produktionsbedingungen insbesondere ohne Autoklaven hergestellt werden.

Um den Zielwerkstoff oder das Endprodukt zu erhalten, kann das erste oder zweite Zwischenprodukt bei einer Temperatur zwischen 100°C und 1000°C, insbesondere zwischen 400°C und 700°C, wärmebehandelt werden, sodass ein Keramikwerkstoff und ein Nebenprodukt entstehen.

In einer weiteren Ausführungsform kann das Nebenprodukt mittels Wasser ausgewaschen werden. Somit kann eine kostengünstige Methode zum Entfernen des Nebenprodukts bereitgestellt werden.

Um ein gut zu verarbeitendes Keramikpulver zu erzeugen, kann der Keramikwerkstoff getrocknet und/oder gemahlen werden, sodass ein Keramikpulver mit feiner Partikelverteilung für eine keramische Formgebung vorliegt.

In einer weiteren Ausführungsform kann ein Hilfsstoff zur Steuerung einer Partikelagglomeration beim Mahlen und/oder beim Trocknen hinzugefügt werden. Als Hilfsstoffe können verschiedene Binder eingesetzt werden.

Eine "Partikelagglomeration" liegt insbesondere dann vor, wenn (Einzel-) Partikel aneinanderhaften und so ein agglomeriertes Partikel aus mehreren Einzelpartikeln gebildet wird.

Um die entstehenden Werkstoffe weiter zu verarbeiten, können entstehende Verfahrensprodukte getrocknet, aufgeschlämmt, abfiltriert und/oder zerkleinert werden.

In einem weiteren Aspekt der Erfindung wird die Aufgabe gelöst durch einen Keramikwerkstoff, insbesondere in Form von Pulver oder Pasten, wobei der Keramikwerkstoff nach einem der zuvor beschriebenen Verfahren erhalten wird.

Somit kann ein Werkstoff bereitgestellt werden, welcher beispielsweise zu einem Grünkörper weiterverarbeitet werden kann.

Es wird ein Formkörper offenbart, welcher aus dem zuvor beschriebenen Keramikwerkstoff hergestellt wird, wobei der Formkörper insbesondere mittels uniaxialem oder kaltisostatischem Pressens, Foliengießens mit gegebenenfalls anschließendem Stapeln und/oder Siebdrucken von grünen Kontaktschichten, PIMs (Power injection moulding), Nasspulverspritzens, Schlickergießens oder Sinterns erhalten wird.

Somit kann ein Formkörper bereitgestellt werden, welcher auf dem technischen Gebiet eine Anwendung findet.

In einer weiteren Ausgestaltung des Formkörpers kann eine metallische Kontaktierung an dem Formkörper insbesondere beim Sintern angebracht werden. Somit kann ein elektronisches Bauteil mit metallischen Anschlüssen bereitgestellt werden.

Um Kosten zu sparen, kann die metallische Kontaktierung eine Ag-Pd-Legierung mit einem Pd-Gehalt von ≤ 25%, bevorzugt ≤ 15 %, besonders bevorzugt ≤ 7,5 % aufweisen. Die Ag-Pd Legierung mit einem Pd-Gehalt von ≤ 25 % kann bei Temperaturen von ≤ 1200°C, bevorzugt von ≤ 1175°C eingesetzt werden. Die Ag-Pd-Legierung mit ≤ 15 % Pd, kann bei Temperaturen von ≤ 1100°C und die Ag-Pd-Legierung mit ≤ 7,5 % Pd kann bei Temperaturen von ≤ 1000°C, bevorzugt von ≤ 950°C eingesetzt werden.

In einer weiteren Ausführungsform kann die metallische Kontaktierung eine Ag-Legierung aufweisen, welche frei von Pd ist. Somit kann eine Alternative zu Ag-Pd-Legierungen bereitgestellt werden.

Es wird ein Verbundkörper offenbart, insbesondere ein Piezo-Element wie es in Entfernungsmessern, Ultraschallwandlern, Ink-Jet-Düsen, Common-Rail-Diesel-Injektoren verwendet wird, wobei der Verbundkörper einen zuvor beschriebenen Formkörper aufweist.

Im Weiteren werden Figuren erläutert. Dabei zeigt
- Fig. 1: ein Herstellungsverfahren für bleihaltige Keramikverbindungen des Standes der Technik,
- Fig. 2: ein Herstellungsverfahren für bleifreie Keramikverbindungen des Standes der Technik,
- Fig. 3: ein erstes erfindungsgemäßes Herstellungsverfahren für bleifreie Keramikverbindungen,
- Fig. 4: ein alternatives erfindungsgemäßes Herstellungsverfahren für bleifreie Keramikverbindungen,
- Fig. 5: zwei Mikroskopieaufnahmen, wobei a) den vergleichenden Werkstoff aus Beispiel 4 und b) den vergleichenden Werkstoff aus Beispiel 5 darstellt,
- Fig. 6: ein Röntgenspektrum zu dem nach dem Beispiel 1 erhaltenen vergleichenden Keramikmaterial,
- Fig. 7: ein Röntgenspektrum zu dem nach dem Beispiel 2 erhaltenen vergleichenden Keramikmaterial,
- Fig. 8: ein Röntgenspektrum zu dem nach dem Beispiel 3 erhaltenen vergleichenden Keramikmaterial,
- Fig. 9: ein Röntgenspektrum zu dem nach dem Beispiel 4 erhaltenen vergleichenden Keramikmaterial und
- Fig. 10: ein Röntgenspektrum zu dem nach dem Beispiel 5 erhaltenen vergleichenden Keramikmaterial.

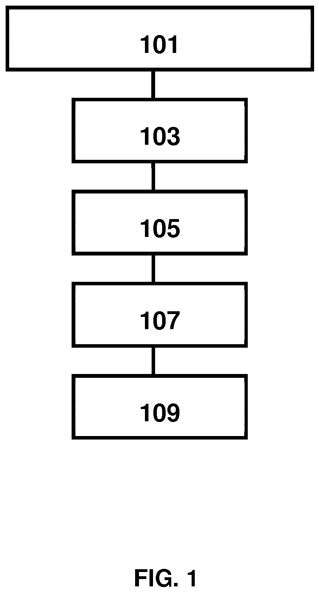

Die prinzipiellen Abläufe zum Herstellen bleihaltiger Verbindungen ist in Figur 1 dargestellt. Als Ausgangsstoffe liegen in einem ersten Schritt 101 beispielsweise PbO, ZrO₂, TiO₂, MgCO₃ und/oder Nb₂O₅ vor. Diese Ausgangsstoffe werden in einem zweiten Schritt 103 in einer Kugelmühle gemahlen und durchmischt. Die Anteile der Ausgangsstoffe werden je nach gewünschtem Zielmaterial bestimmt.

In einem weiteren Schritt 105 werden die gemischten Ausgangsstoffe bei hohen Temperaturen wie beispielsweise 1000°C kalziniert. Das kalzinierte Material wird anschließend 107 abermals in einer Kugelmühle gemahlen und durchmischt, sodass letztendlich abschließend 109 das gewünschte Keramikpulver vorliegt.

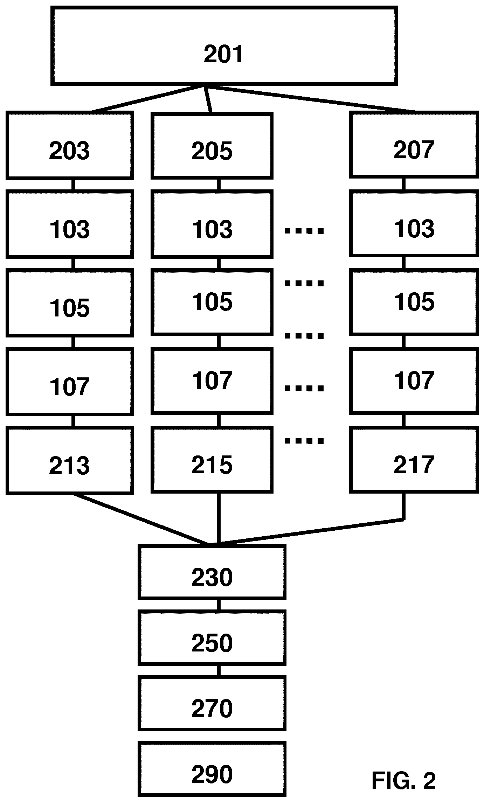

In Figur 2 ist der Stand der Technik zum prinzipiellen Herstellen bleifreier Keramkverbindungen dargestellt. Zum Herstellen bleifreier Verbindungen liegen anfänglich 201 Ausgangsstoffe wie Nb₂O₅, Ta₂O₅, Na₂CO₃, K₂CO₃, Li₂C0₃ und/oder Sb₂O₅ vor. Diese Ausgangsstoffe werden beispielsweise paarweise gemischt. Als Beispiele seien hier folgende Mischungen angegeben Na₂CO₃ und Nb₂O₅ 203, Ta₂O₅ und Li₂CO₃ 205 oder K₂CO₃ und Sb₂O₅, 207.

Diese Mischungen 203, 205, 207 werden in einem folgenden Schritt 103 gemischt und gemahlen. Anschließend 105 erfolgt ein Kalzinieren und darauf folgend 107 ein weiteres Mischen und Mahlen, sodass beispielsweise für die erste Mischung 203 das Gemisch NaNbO₃ 213, für die zweite Mischung 205 das Gemisch LiTaO₃ 215 und als letzte Beispielsmischung 207 das Gemisch KSbO₃ 217 vorliegt.

Die neu hergestellten Mischungen 213, 215, 217 werden in einem weiteren Schritt 230 in einer Kugelmühle gemahlen und gemischt. Im darauffolgenden Schritt 250 erfolgt ein Kalzinieren, auf welches ein weiterer Schritt 270 aus Mahlen in der Kugelmühle und Durchmischen folgt. Nach diesem Verfahren liegt abschließend 290 ein bleifreies Keramikpulver vor.

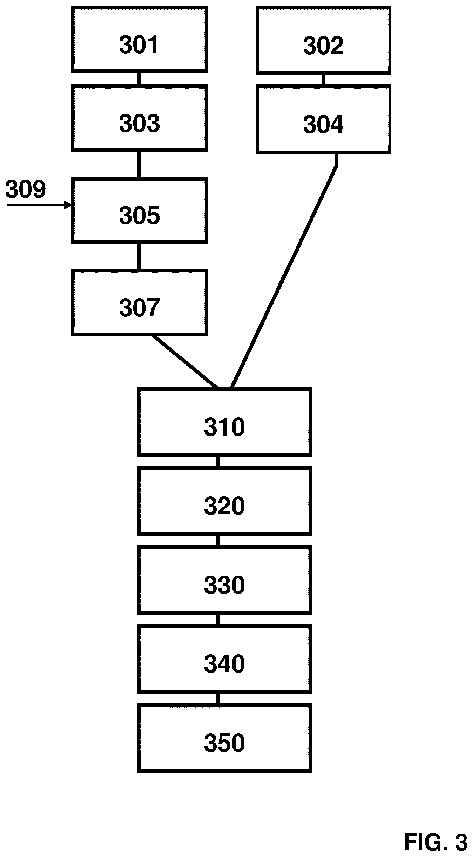

In Figur 3 ist eine prinzipielle Darstellung des erfindungsgemäßen Herstellungsverfahrens dargestellt. Anfänglich 301, 302 liegen in HF gelöste Fluorokomplexe 301 und wässrige Hydroxide und/oder Hydroxokomplexe 302 vor.

Die in HF gelösten Fluorokomplexe 301 sind beispielsweise H₂NbF₇, H₂TaF₇, HSbF₆, H₂ZrF₆, H₂SiF₆ und/oder H₃AlF₆. Diese in HF gelösten Fluorokomplexe 301 werden in einem ersten Schritt 303 gemischt. Durch Hinzufügen 309 einer basischen Lösung wie NH₃, KOH, LiOH, NaOH, RbOH, Ca(OH)₂ und/oder H₂Zn(OH)₄ werden in einem weiteren Schritt 305 die gemischten Lösungen gefällt und gewaschen, wodurch anschließend eine Hydroxidsuspension 307 vorliegt.

Die anfänglich vorliegenden wässrigen Hydroxide und/oder Hydroxidkomplexe 302 werden in einem weiteren Verfahrensschritt 304 gemischt. Wässrige Hydroxide bzw. Hydroxidkomplexe sind insbesondere KOH, LiOH, NaOH, RbOH, Ca(OH)₂ und/oder ein Hydroxidkomplex der Elemente ausgewählt aus der Gruppe Zink, Aluminium, Antimon oder Zinn. Ein Zinkkomplex kann z.B. als eine Verbindung der chemischen Zusammensetzung H₂Zn(OH)₄ vorliegen.

Die gemischten wässrigen Hydroxide und/oder Hydroxidkomplexe 304 werden in einem weiteren Schritt 310 mit der Hydroxidsuspension 307 in einem Rührwerk gemischt. Anschließend wird diese Mischung 310 filtriert 320, getrocknet und kalziniert 330, anschließend nochmal gemahlen und gewaschen 340, wodurch abschließend ein Keramikpulver 350 vorliegt.

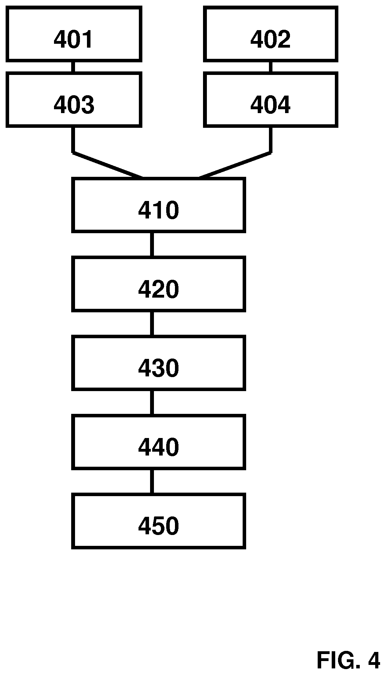

In Figur 4 ist ein alternatives erfindungsgemäßes Herstellungsverfahren dargestellt. In Fluorwasserstoff gelöste Fluorokomplexe wie H₂NbF₇, H₂TaF₇, HSbF₆, H₂ZrF₆, H₂SiF₆ und/oder H₃AlF₆ liegen anfänglich 401 vor. Wenigstens zwei gelöste Fluorokomplexe werden in einem weiteren Schritt 403 gemischt.

Parallel dazu liegen anfänglich 402 wässrige Hydroxide und/oder Hydroxidkomplexe wie KOH, LiOH, NaOH, RbOH, Ca(OH)₂ und/oder ein Hydroxidkomplex der Elemente ausgewählt aus der Gruppe Zink, Aluminium, Antimon oder Zinn vor. Diese werden in einem weiteren Schritt 404 gelöst und wenigstens zwei Hydroxide und/oder Hydroxokomplexe gemischt.

Die gemischten Fluorokomplexe nach dem Mischungsschritt 403 werden mittels der Mischungen der wässrigen Hydroxide oder Hydroxokomplexe nach Schritt 404 in einem nächsten Schritt 410 gefällt. Darauffolgend 420 wird das gefällte Produkt gewaschen und filtriert. Das filtrierte Produkt wird in einem weiteren Schritt 430 getrocknet und kalziniert, worauf anschließend 440 das kalzinierte Produkt gemahlen und gewaschen wird. Abschließend 450 liegt das gewünschte Keramikpulver vor.

Im Weiteren werden exemplarisch Herstellungsverfahren für einzelne bleifreie Keramiken für piezoelektrische Bauteile dargestellt.

### Beispiele

### Vergleichsbeispiel 1

In einem ersten Beispiel soll (K_{0,52}Na_{0,44}Li_{0,04})(Nb_{0,86}Ta_{0,10}Sb_{0,04})P₃ hergestellt werden. Dazu werden 3,160 l einer H₂NbF₇-Lösung in Flusssäure (40%) mit einer Beladung von 126,6g Nb₂O₅ pro Liter und 0,516 l einer H₂TaF₇-Lösung in Flusssäure (40%) mit einer Beladung von 149,84g Ta₂O₅ pro Liter in einem 2l-Teflonbecher gemischt, 20,4g Sb₂O₅ zugegeben und 2 Tage gerührt.

Nach der Filtration des Feststoffes wird das Mischhydroxid mittels Ammoniaklösung (25%) bis pH-9 gefällt. Dabei wurde bis pH=6 Lackmuspapier und anschließend eine Glaselektrode zur Bestimmung des pH-Wertes verwendet. Die Suspension wird filtriert und der Rückstand mit 5l Ammoniakwasser (3%) und danach mit 2l Wasser gewaschen.

Zur Überprüfung der Zusammensetzung des Oxids wurde das erhaltene Produkt analysiert. Dazu wurde ein Teil in Porzellanschalen 18 Std. bei 105°C getrocknet und bei 1000°C kalziniert. Die Analyse entspricht in der Suspension der Verbindung (Nb_{0,86}Ta_{0,10}Sb_{0,04})(OH)₅.

Zur Herstellung der Keramikmasse werden unter langsamer Zugabe über einen Zeitraum von 30 Minuten 49,35g KOH, 41,4g NaOH, 3,26g LiOH*H₂O in 100ml deionisiertem H₂O (VE) gelöst und separat 539,19g (Nb_{0,86}Ta_{0,10}Sb_{0,04})(OH)₅ eingewogen. Die dickflüssige (Nb_{0,86}Ta_{0,10}Sb_{0,04})(OH)₅ Suspension wird mit einem Mischer (Mulinette) 5min dispergiert. Nach Abkühlen auf Raumtemperatur wird die obige Laugenlösung portionsweise (in 10 Einzeldosen innerhalb einer Stunde) zugegeben und 1 Std. gerührt. Die Suspension wird filtriert und die Rückstände werden 17 Stunden bei 60°C getrocknet, dann aufgeschlämmt, dann abfiltriert und bei 60°C getrocknet und anschließend zerkleinert und bei 600°C für 2 Stunden kalziniert, anschließend aufgeschlämmt und abfiltriert, nochmals getrocknet und bei 120°C zerkleinert. Die Analyse der daraus entstehenden Keramikmasse entspricht mit (K_{0,55}Na_{0,43}Li_{0,02})(Nb_{0,86}Ta_{0,10}Sb_{0,03})O₃ im Rahmen der Analysenungenauigkeit der gewünschten Verbindung.

Diese Keramikmasse kann beispielsweise zu Sintertabletten weiterverarbeitet werden. Dazu wird das Keramikpulver gemahlen bis die mittlere Partikelgröße gemessen mit Mastersizer (Malvern, Laserbeugung) gemäß ASTM B 822 kleiner als 5< µm und mit einer isostatischen Presse zu Tabletten von 1cm Durchmesser und etwa 2mm Höhe gepresst. Gesintert werden die Tabletten bei 980°C für 2 Stunden. Es ergeben sich Presslinge mit Sinterdichten von rund 97% der theoretischen Dichte.

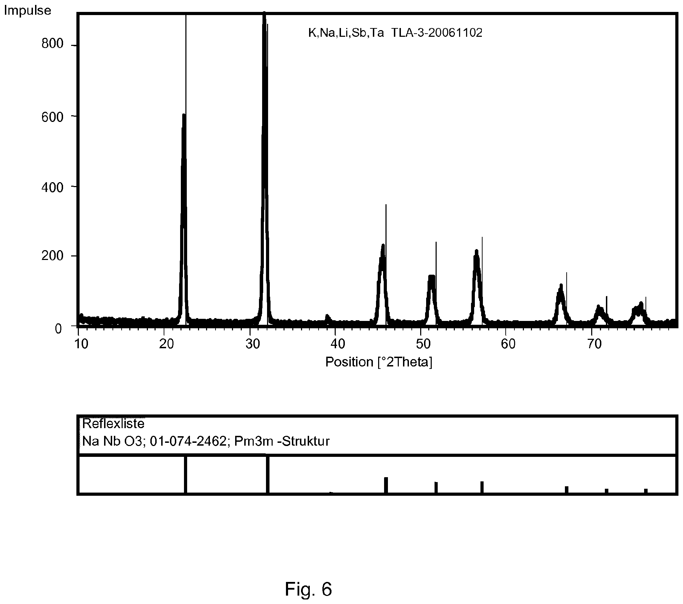

Das Röntgenspektrum des nach Beispiel 1 erhaltenen Keramikmaterials ist in Fig. 6 zu sehen.

### Vergleichsbeispiel 2

In einem zweiten Beispiel soll (K_{0,52}Na_{0,44}Zn_{0,04})(Nb_{0,86}Ta_{0,10}Sb_{0,04})O₃ hergestellt werden. Dazu werden 3,160 l einer H₂NbF₇-Lösung in Flusssäure (40%) mit einer Beladung von 126,6g Nb₂O₅ pro Liter und 0,516 l einer H₂TaF₇-Lösung in Flusssäure (40%) mit einer Beladung von 149,84g Ta₂O₅ pro Liter in einem 2l-Teflonbecher gemischt, 20,4g Sb₂O₅ zugegeben und 2 Tage gerührt. Nach der Filtration des Feststoffes wird das Mischhydroxid mittels Ammoniaklösung (25%) bis pH-9 gefällt. Dabei wurde bis pH=6 Lackmuspapier und anschließend eine Glaselektrode zur Bestimmung des pH-Wertes verwendet. Die Suspension wird filtriert und der Rückstand mit 5l Ammoniakwasser und danach mit 2l Wasser gewaschen.

Zur Überprüfung der Zusammensetzung des Oxids wurde das erhaltene Produkt analysiert. Dazu wurde ein Teil in Porzellanschalen 18 Std. bei 105°C getrocknet und bei 1000°C kalziniert. Die Analyse entspricht in der Suspension der Verbindung (Nb_{0,86}Ta_{0,10}Sb_{0,04})(OH)₅.

Zur Herstellung der Keramikmasse werden vorsichtig unter langsamer Zugabe über einen Zeitraum von 30 Minuten 49,35g KOH, 41,4g NaOH, 5,46g ZnCl2 in 100ml deionisiertem H₂O (VE) gelöst und separat 208,92g des (Nb_{0,86}Ta_{0,10}Sb_{0,04})(OH)₅-Pulvers eingewogen und in 100ml H₂O aufgeschlämmt. Die dickflüssige (Nb_{0,86}Ta_{0,10}Sb_{0,04})(OH)₅ Suspension wird mit einem Shaker (Mulinette) 30min dispergiert. Nach Abkühlen auf Raumtemperatur wird die obige Laugenlösung portionsweise (in 10 Einzeldosen innerhalb einer Stunde) zugegeben und 5 Std. gerührt. Die Suspension wird filtriert und die Rückstände werden 17Std. bei 60°C getrocknet, dann aufgeschlämmt, dann abfiltriert und bei 60°C für 17Std. getrocknet und anschließend zerkleinert und bei 600°C für 2 Std. kalziniert, dann aufgeschlämmt, anschließend abfiltriert, bei 120°C getrocknet und zerkleinert. Die Analyse der daraus entstehenden Keramikmasse entspricht mit (K_{0,47}Na_{0,43}Zn_{0,02})(Nb_{0,85}Ta_{0,09}Sb_{0,04})O₃ im Rahmen der Messungenauigkeit der gewünschten Verbindung.

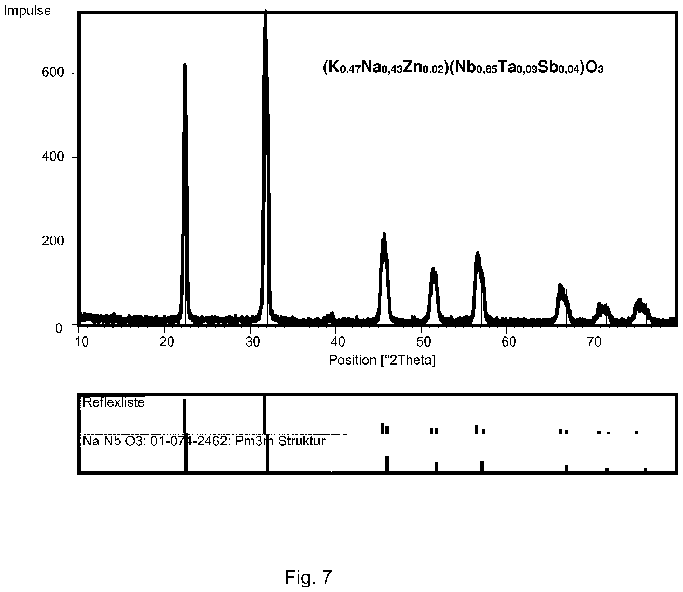

Das Röntgenspektrum des nach Beispiel 2 erhaltenen Keramikmaterials ist in Fig. 7 zu sehen.

### Vergleichsbeispiel 3

In einem dritten Beispiel soll (K_{0,52}Na_{0,44}Cu_{0,04})(Nb_{0,86}Ta_{0,10}Sb_{0,04})O₃ hergestellt werden. Dazu werden 3,160 l einer H₂NbF₇-Lösung in Flusssäure (40%) mit einer Beladung von 126,6g Nb₂O₅ pro Liter und 0,516 l einer H₂TaF₇-Lösung in Flusssäure (40%) mit einer Beladung von 149,84g Ta₂O₅ pro Liter in einem 2l-Teflonbecher gemischt, 20,4g Sb₂O₅ zugegeben und 2 Tage gerührt.

Nach der Filtration des Feststoffes wird das Mischhydroxid mittels Ammoniaklösung (25%) bis pH-9 gefällt. Dabei wurde bis pH=6 Lackmuspapier und anschließend eine Glaselektrode zur Bestimmung des pH-Wertes verwendet. Die Suspension wird filtriert und der Rückstand mit 5l Ammoniakwasser und danach mit 2l Wasser gewaschen.

Zur Überprüfung der Zusammensetzung des Oxids wurde das erhaltene Produkt analysiert. Dazu wurde ein Teil in Porzellanschalen 18 Std. bei 105°C getrocknet und bei 1000°C kalziniert. Die Elementaranalyse des Oxids entspricht in der Suspension der Verbindung (Nb_{0,86}Ta_{0,10}Sb_{0,04})(OH)₅.

Zur Herstellung der Keramikmasse werden vorsichtig unter langsamer Zugabe über einen Zeitraum von 30 Minuten 49,35g KOH, 41,4g NaOH, 4,42g Cu₂CO₃(OH)₂ in 100ml deionisiertem H₂O (VE) gelöst und separat 208,92g (Nb_{0,86}Ta_{0,10}Sb_{0,04})(OH)₅ eingewogen. Die dickflüssige (Nb_{0,86}Ta_{0,10}Sb_{0,04})(OH)₅ Suspension wird 30min dispergiert. Nach Abkühlen auf Raumtemperatur wird die obige Laugenlösung portionsweise (in 10 Einzeldosen innerhalb einer Stunde) zugegeben und 5 Stunden gerührt. Die Suspension wird filtriert und die Rückstände werden 17 Stunden bei 60°C getrocknet, dann nacheinander erst mit 500ml halbkonzentrierter HNO₃ und dann mit 1l Wasser und 500ml Ammoniakwasser aufgeschlämmt, dann abfiltriert und 17 Stunden bei 60°C getrocknet und anschließend zerkleinert und bei 600°C für 2 Stunden kalziniert, anschließend aufgeschlämmt und abfiltriert, nochmals getrocknet und bei 120°C zerkleinert. Die Analyse der daraus entstehenden Keramikmasse entspricht mit (K_{0,51}Na_{0,40}CU_{0,01})(Nb_{0,85}Ta_{0,9}Sb_{0,04})O₃ im Rahmen der Analysengenauigkeit der gewünschten Verbindung.

Bei den Beispielen 1 bis 3 hat sich gezeigt, dass die Kalzinierungstemperaturen deutlich abgesenkt werden können und ein Abdampfen des leichtflüchtigen Kaliumoxids eingeschränkt oder vermindert wird. Als Kalzinierungstemperaturen sind insbesondere Temperaturen zwischen 400°C und 900°C und bevorzugt Temperaturen zwischen 500°C und 700°C einsetzbar.

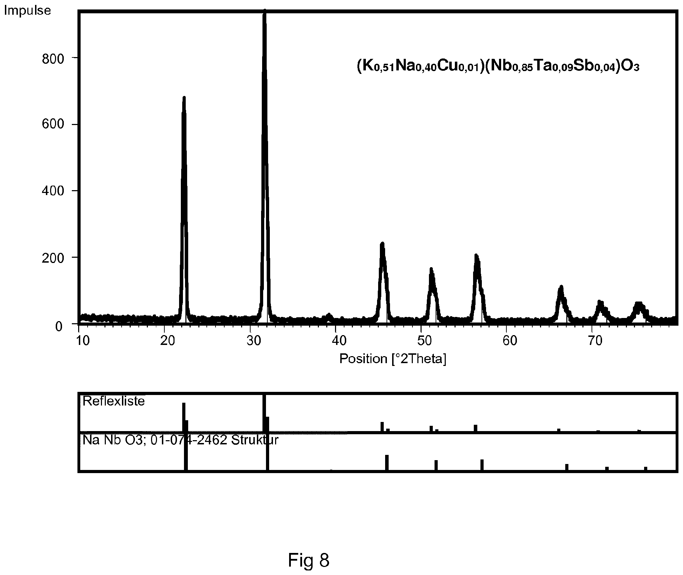

Das Röntgenspektrum des nach Beispiel 3 erhaltenen Keramikmaterials ist in Fig. 8 zu sehen.

### Vergleichsbeispiel 4

In einem vierten Beispiel soll (K_{0,52}Na_{0,44}Li_{0,04})(Nb_{0,86}Ta_{0,10}Sb_{0,04})O₃ mit regulären Partikeln hergestellt werden. Dazu werden 448,8g KOH, 414,0g NaOH, 16,3g LiOH*H₂O in 1600ml deionisiertem H₂O (VE) gelöst. Dann werden 311,2 ml H₂TaF₇-Lösung in Flusssäure (c=142g/l) und 2033,9 ml H₂NbF₇ in Flusssäure (c=113g/l) in einem Teflonbecher gemischt und 21,02g KSb(OH)₆ zugegeben. Nach Abkühlen der flusssauren Lösung auf Raumtemperatur wird die Laugenlösung tropfenweise innerhalb von 120 min. zugegeben.

Am Ende hat die trübe Mischung einen pH-Wert von 12,3, wobei sie noch weitere 3 Stunden gerührt wird. Die Suspension wird filtriert und die Rückstände mit 10l NH₃ 3% (Ammoniakwasser) und mit 10l deionisiertes Wasser gewaschen. Anschließend wird die Suspension 17 Stunden bei 60°C getrocknet und anschließend zerkleinert. Der Feststoff wird bei 600°C für 2 Std. kalziniert, anschließend mit 10 Liter NH₃ 3% (Ammoniakwasser) und mit 10 Liter deionisiertem Wasser gewaschen und 17 Stunden bei 160°C getrocknet und zerkleinert.

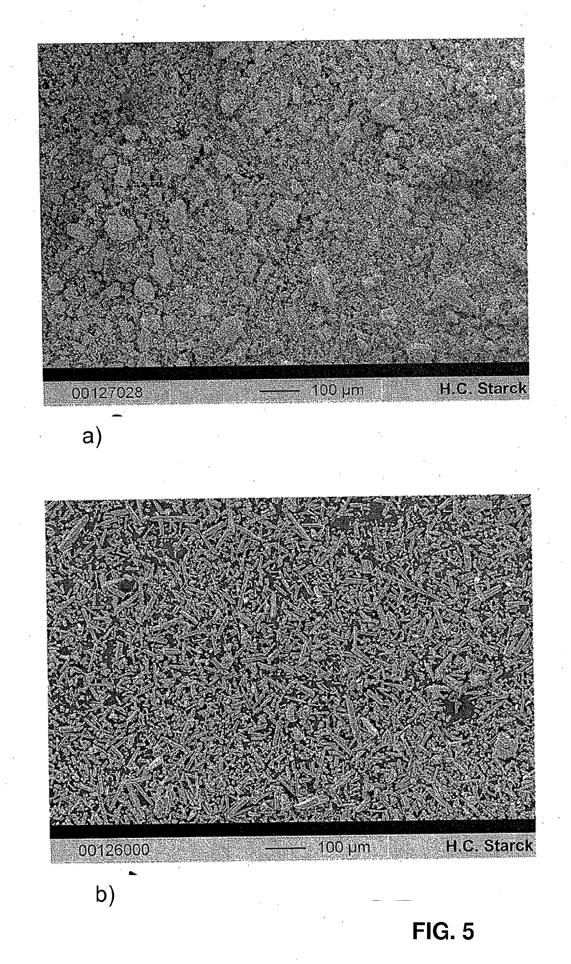

Die Analyse der daraus entstehenden Keramikmasse entspricht (K_{0,46}Na_{0,42}Li_{0,05})(Nb_{0,82}Ta_{0,11}Sb_{0,04})O₃. Die Verbindung zeigt unter dem Mikroskop (Lichtmikroskop, 10x) zu einem sehr kleinen Teil stäbchenförmige Nadeln und zum größten Teil sehr feine Partikel wie der Figur 5 a) zu entnehmen ist.

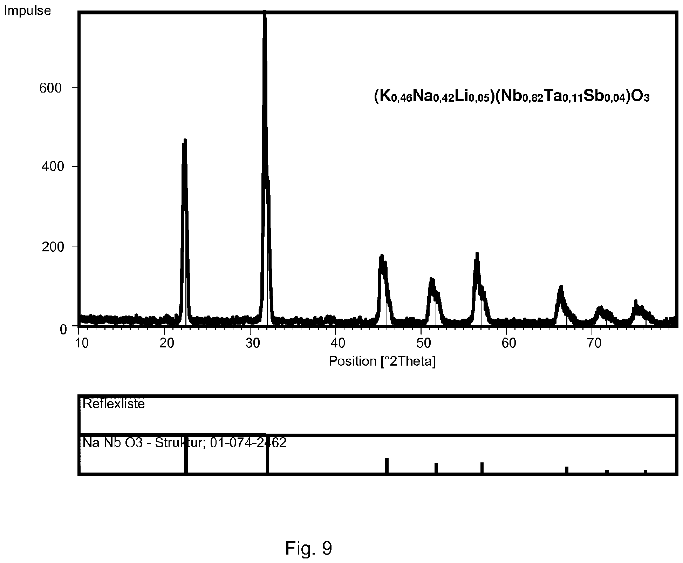

Das Röntgenspektrum des nach Beispiel 4 erhaltenen Keramikmaterials ist in Fig. 9 zu sehen.

### Vergleichsbeispiel 5

In einem fünften Beispiel soll (K_{0,16}Na_{0,80}Li_{0,04})(Nb_{0,86}Ta_{0,10}Sb_{0,04})O₃ mit stäbchenförmigen Partikeln hergestellt werden. Dazu werden vorsichtig 224,4g KOH, 207,0g NaOH, 8,15g LiOH*H₂O in 800ml deionisiertem H₂O (VE) gelöst. Dann werden 147,3 ml H₂TaF₇-Lösung in Flusssäure (c=150g/l) und 960,5 ml H₂NbF₇ in Flusssäure (c=116g/l) in einem Teflonbecher gemischt und 10,51g KSb(OH)₆ zugegeben. Nach Abkühlen der flusssauren Lösung auf Raumtemperatur wird die Laugenlösung tropfenweise innerhalb von 105 min. bis zu einem pH-Wert von 12,5 zugegeben. In diesem Moment beginnt die Bildung einer stäbchenförmigen Phase, wie der Mikroskopaufnahme aus Figur 5 b) entnommen werden kann.

Die Suspension wird für 30 min. gerührt bevor die restliche Lauge zugetropft wird. Am Ende hat die trübe Mischung einen pH-Wert von 14, wobei sie noch weitere 4 Stunden gerührt wird. Die Suspension wird filtriert und die Rückstände mit 5l NH₃ 3% (Ammoniakwasser) und mit 5 Liter deionisiertem Wasser gewaschen. Anschließend wird die Suspension 17 Stunden bei 60°C getrocknet und anschließend zerkleinert. Der Feststoff wird bei 600°C für 2 Stunden kalziniert, anschließend mit 5 Liter NH₃ 3% (Ammoniakwasser) und mit 5 Liter deionisiertes Wasser gewaschen und 17 Stunden bei 160°C getrocknet und zerkleinert.

Die Analyse der daraus entstehenden Keramikmasse entspricht (K_{0,16}Na_{0,79}Li_{0,01})(Nb_{0,88}Ta_{0,10}Sb_{0,03})O₃. Die Verbindung zeigt unter dem Mikroskop (Lichtmikroskop, 10x) stäbchenförmige Nadeln wie der REM-Aufnahme Figur 5 b) zu entnehmen ist.

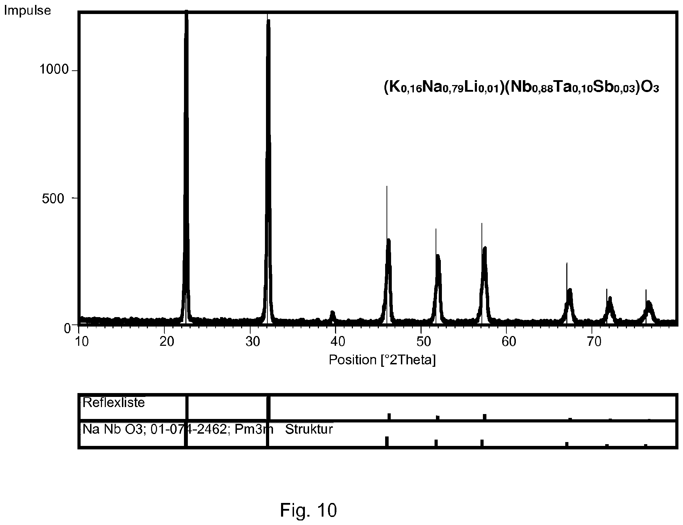

Das Röntgenspektrum des nach Beispiel 5 erhaltenen Keramikmaterials ist in Fig. 10 zu sehen.

Die Keramikwerkstoffe aus den Beispielen 1 bis 5 sind homogen aufgebaut, wie den Röntgenspektren der Figuren 6 bis 10 zu entnehmen ist.

## Patentansprüche

1. Verfahren zum Herstellen eines homogenen Mehrstoffsystems auf Hydroxid- und /oder Oxidbasis, insbesondere eines homogenen Mehrstoffsystems mit einer stäbchenförmigen Morphologie, wobei das Mehrstoffsystem ein erstes Element aus der Gruppe Mo, W, Nb, Re, Zr, Hf, V, Sb, Si, Al und Ta und ein zweites Element aus der Gruppe Mo, W, Nb, Re, Zr, Hf, V, Sb, Si, Al und Ta aufweist und wobei das erste Element und das zweite Element unterschiedlich sind, wobei das erste oder das zweite Element, oder das erste und das zweite Element als Fluor-, oder Oxifluorkomplex, oder als Fluor- und Oxifluorkomplex vorliegt, wobei in der ersten Alternative das erste Element in einer ersten flusssauren Lösung und das zweite Element in einer zweiten flusssauren Lösung vorliegen und die erste flusssaure Lösung mit dem ersten Element und die zweite flusssaure Lösung mit dem zweiten Element gemischt wird, sodass eine flusssaure Mischlösung mit gelöstem ersten und zweiten Element vorliegt,
oder
in einer zweiten Alternative das erste Element und das zweite Element in einer alternativen flusssauren Mischlösung gelöst sind
und
abschließend die flusssaure Mischlösung oder die alternative flusssaure Mischlösung mit einem Fällungsmittel gefällt wird, sodass ein Feststoffgemisch in einer Suspension vorliegt, wobei das Fällungsmittel eine basische Lösung, eines basisch wirkenden Feststoffes oder eines basisch wirkenden Gases ist und das Fällen bei einem PH-Wert zwischen 6,5 und 14 der flusssauren Mischlösung oder der alternativen flusssauren Mischlösung erfolgt.

2. Verfahren nach Anspruch 1, **dadurch gekennzeichnet, dass** das erste oder das zweite Element, oder das erste und das zweite Element als H₂NbF₇, H₂TaF₇, HSbF₆, H₂ZrF₆, H₂SiF₆, H₃AlF₆ vorliegt.

3. Verfahren nach Anspruch 1 oder 2, **dadurch gekennzeichnet, dass** der flusssauren Mischlösung oder der alternativen flusssauren Mischlösung eine dritte oder weitere flusssaure Lösungen mit einem gelösten dritten oder weiteren Element aus der Gruppe Mo, W, Nb, Re, Zr, Hf, V und Ta vor dem Fällen zugemischt wird.

4. Verfahren nach einem der vorherigen Ansprüche, **dadurch gekennzeichnet, dass** in der flusssauren Mischlösung oder der alternativen flusssauren Mischlösung ein drittes oder weiteres Element aus der Gruppe Mo, W, Nb, Re, Zr, Hf, V und Ta vor dem Fällen gelöst wird.

5. Verfahren nach einem der vorherigen Ansprüche, **dadurch gekennzeichnet, dass** ein Dotierelement aus der Gruppe Ti, Zr, Sn, Fe, Co, Ni, Ca, Zn, Pd, Cd, Al, Si, P, Ge, As, Se, Sb, Te, Sc, Y, Yb
in zumindest einer Lösung gelöst ist, ausgewählt aus der Gruppe bestehend aus
(a) ersten flusssauren Lösung,
(b) zweiten flusssauren Lösung,
(c) alternativen flusssauren Mischlösung,
(d) Fällungsmittel,
(e) ersten flusssauren Dotierelementlösung,
wobei im Falle, dass das Dotierelement in der Dotierelementlösung oder in dem Fällungsmittel oder in beiden gelöst ist, die Dotierelementlösung, oder das Fällungsmittel oder beide der ersten flusssauren Lösung, der zweiten flusssauren Lösung, der flusssauren Mischlösung oder der alternativen flusssauren Mischlösung zugegeben wird, sodass das Dotierelement wenigstens teilweise als Oxid oder Hydroxid beim Fällen ausfällt.

6. Verfahren nach Anspruch 5, **dadurch gekennzeichnet, dass** die basische Lösung eine erste Alkalihydroxidlösung, oder eine erste Erdalkalihydroxidlösung, oder beide, oder eine erste Mischung mehrerer Alkalihydroxidlösungen, oder eine erste Mischung mehrerer Erdalkalihydroxidlösungen, oder beide oder eine erste Mischung einer oder mehrerer Alkalihydroxid-Lösungen, oder eine erste Mischung oder beide, einer/oder mehrerer Erdalkalihydroxid-Lösungen enthält, wobei die Alkali- oder Erdlakalihydroxid-Lösungen oder beide mindestens ein gelöstes amphoteres Element aufweisen,
wobei die erste Alkalihydroxidlösung ein erstes Alkalielement und die erste Erdalkalihydroxidlösung ein erstes Erdalkalielement und die erste Mischung mehrerer Alkalihydroxidlösungen mehrere Alkalielemente und die erste Mischung mehrerer Erdalkalihydroxidlösungen mehrere Erdalkalielemente aufweist, sodass sich eine erste Suspension mit einem ersten Zwischenprodukt ergibt, welches im Feststoffanteil ein erstes Alkalielement oder eine Mischung mehrerer Alkalielemente, oder ein erstes Erdalkalielement oder beide, oder eine Mischung von Erdalkalielementen gleichmäßig verteilt aufweist.

7. Verfahren nach Anspruch 6, wobei die erste Alkalihydroxidlösung oder die erste Erdalkalihydroxidlösung, oder beide ein wässriges Hydroxid oder ein Hydroxidkomplex, oder wässriges Hydroxid und Hydroxidkomplex aufweist.

8. Verfahren nach Anspruch 7, wobei das wässrige Hydroxid mindestens ein Alkalihydroxid ausgewählt aus der Gruppe bestehend aus KOH, LiOH, NaOH, RbOH, Ca(OH)₂, und mindestens ein Hydroxidkomplex der Elemente ausgewählt aus der Gruppe Zink, Aluminium, Antimon, Zinn aufweist.

9. Verfahren nach einem der vorgehenden Ansprüche, **dadurch gekennzeichnet, dass** die Suspension filtriert wird, sodass das Feststoffgemisch als Suspensionsrückstand vorliegt.

10. Verfahren nach Anspruch 8, **dadurch gekennzeichnet, dass** der Suspensionsrückstand gewaschen wird.

11. Verfahren nach einem der vorherigen Ansprüche, **dadurch gekennzeichnet, dass** die Suspension oder der Suspensionsrückstand getrocknet wird, sodass ein getrockneter Rückstand vorliegt.

12. Verfahren nach einem der vorherigen Ansprüche, **dadurch gekennzeichnet, dass** die Suspension oder der Suspensionsrückstand durchmischt wird.

13. Verfahren nach einem der vorherigen Ansprüche, **dadurch gekennzeichnet, dass** der Suspension, dem Suspensionsrückstand, dem getrockneten Rückstand, dem durchmischten Suspensionsrückstand oder der durchmischten Suspension eine basische Lösung auf wässriger oder organischer Basis zugegeben wird, sodass sich ein erstes Zwischenprodukt ergibt.

14. Verfahren nach Anspruch 10, **dadurch gekennzeichnet, dass** die Zugabe der basischen Lösung unter Rühren erfolgt.

15. Verfahren nach Anspruch 13 oder 14, **dadurch gekennzeichnet, dass** die basische Lösung eine Alkalihydroxidlösung und/oder eine Erdalkalihydroxidlösung oder eine Mischung mehrerer Alkalihydroxidlösungen und/oder eine Mischung mehrerer Erdalkalihydroxidlösungen aufweist, wobei die Alkalihydroxidlösung ein Alkalielement und die Erdalkalihydroxidlösung ein Erdalkalielement und die Mischung mehrerer Alkalihydroxidlösungen mehrere Alkalielemente und die Mischung mehrerer Erdalkalihydroxidmischungen mehrere Erdalkalielemente aufweist, sodass sich ein zweites Zwischenprodukt ergibt, welches ein Alkalielement oder eine Mischung mehrerer Alkalielemente oder ein Erdalkalielement oder eine Mischung von Erdalkalielementen gleichmäßig verteilt, aufweist.

16. Verfahren nach einem der Ansprüche 13 bis 15, **dadurch gekennzeichnet, dass** das Zugeben der basischen Lösung bei Temperaturen zwischen 0°C und 40°C, insbesondere bei Raumtemperatur, und einem Druck zwischen 800 mbar und 1200 mbar, insbesondere unter Normaldruck, erfolgt.

17. Verfahren nach einem der vorhergehenden Ansprüche 6 bis 16, **dadurch gekennzeichnet, dass** das erste oder zweite Zwischenprodukt bei einer Temperatur zwischen 100°C und 1000°C, insbesondere zwischen 400°C und 700°C, wärmebehandelt wird, sodass ein Keramikwerkstoff und ein Nebenprodukt entsteht.

18. Verfahren nach Anspruch 17, **dadurch gekennzeichnet, dass** das Nebenprodukt mittels Wasser ausgewaschen wird.

19. Verfahren nach Anspruch 18, **dadurch gekennzeichnet, dass** der Keramikwerkstoff getrocknet und/oder gemahlen wird, sodass ein homogenes Keramikpulver für eine keramische Formgebung vorliegt.

20. Verfahren nach Anspruch 19, **dadurch gekennzeichnet, dass** ein Hilfsstoff zur Steuerung einer Partikelagglomeration beim Mahlen und/oder beim Trocknen hinzugefügt wird.

21. Verfahren nach einem der vorherigen Ansprüche, **dadurch gekennzeichnet, dass** entstehende Verfahrensprodukte getrocknet, aufgeschlämmt, abfiltriert und/oder zerkleinert werden.

22. Keramikwerkstoff, insbesondere in Form von Pulver oder Pasten, **dadurch gekennzeichnet, dass** der Keramikwerkstoff nach einem Verfahren nach einem der Ansprüche 1 bis 21 erhalten wird.

23. Verfahren zur Herstellung eines Formkörpers **dadurch gekennzeichnet, dass** der Formkörper aus dem Keramikwerkstoff nach Anspruch 22 durch uniaxiales oder kaltisostatisches Pressen, Foliengießen mit gegebenenfalls anschließendem Stapeln und/oder Siebdrucken von grünen Kontaktschichten, PIMs (Power injection moulding), Nasspulverspritzen, Schlickergießen oder Sintern erhalten wird.

24. Verfahren nach Anspruch 23, **dadurch gekennzeichnet, dass** eine metallische Kontaktierung an dem Formkörper insbesondere beim Sintern angebracht wird.

25. Verfahren nach Anspruch 24, **dadurch gekennzeichnet, dass** die metallische Kontaktierung eine Ag-Pd-Legierung mit einem Pd-Gehalt von ≤ 25%, bevorzugt ≤ 15%, besonders bevorzugt von ≤ 7,5 % aufweist.

26. Verfahren nach Anspruch 24, **dadurch gekennzeichnet, dass** die metallische Kontaktierung eine Ag-Legierung aufweist, welche frei von Pd ist.

27. Verwendung eines Formkörpers erhältlich nach einem Verfahren nach Anspruch 23 to 26 zur Herstellung eines Verbundkörpers, insbesondere eines Piezo-Elements wie es in Entfernungsmessern, Ultraschallwandlern, Ink-Jet-Düsen, Common-Rail-Diesel-Injektoren verwendet wird.

## Claims

1. Process for producing a homogeneous multicomponent system having a hydroxide and/or oxide basis, in particular a homogeneous multicomponent system having a rod-shaped morphology, where the multicomponent system comprises a first element from the group consisting of Mo, W, Nb, Re, Zr, Hf, V, Sb, Si, Al and Ta and a second element from the group consisting of Mo, W, Nb, Re, Zr, Hf, V, Sb, Si, Al and Ta and the first element and the second elements are different, where the first element or the second element or the first element and the second element is/are present as fluoro or oxyfluoro complex or as fluoro and oxyfluoro complex, where, in the first alternative, the first element is present in a first hydrofluoric acid solution and the second element is present in a second hydrofluoric acid solution and the first hydrofluoric acid solution containing the first element and the second hydrofluoric acid solution containing the second element are mixed so as to give a hydrofluoric acid mixed solution containing the dissolved first element and second element,
or
in a second alternative, the first element and the second element are present in dissolved form in an alternative hydrofluoric acid mixed solution,
and
the hydrofluoric acid mixed solution or the alternative hydrofluoric acid mixed solution is finally precipitated by means of a precipitant so as to give a solid state mixture in a suspension, where the precipitant is a basic solution, a solid having a basic reaction or a gas having a basic reaction and the precipitation is carried out at a pH in the range from 6.5 to 14 of the hydrofluoric acid mixed solution or of the alternative hydrofluoric acid mixed solution.

2. Process according to Claim 1, **characterized in that** the first element or the second element or the first element and the second element is/are present as H₂NbF₇, H₂TaF₇, HSbF₆, H₂ZrF₆, H₂SiF₆, H₃AlF₆.

3. Process according to Claim 1 or 2, **characterized in that** a third or further hydrofluoric acid solution containing a dissolved third or further element from the group consisting of Mo, W, Nb, Re, Zr, Hf, V and Ta is mixed into the hydrofluoric acid mixed solution or the alternative hydrofluoric acid mixed solution before precipitation.

4. Process according to any of the preceding claims, **characterized in that** a third or further element from the group consisting of Mo, W, Nb, Re, Zr, Hf, V and Ta is dissolved in the hydrofluoric acid mixed solution or the alternative hydrofluoric acid mixed solution before precipitation.

5. Process according to any of the preceding claims, **characterized in that** a doping element from the group consisting of Ti, Zr, Sn, Fe, Co, Ni, Ca, Zn, Pd, Cd, Al, Si, P, Ge, As, Se, Sb, Te, Sc, Y, Yb is present in dissolved form in at least one solution selected from the group consisting of
(a) the first hydrofluoric acid solution,
(b) the second hydrofluoric acid solution,
(c) the alternative hydrofluoric acid mixed solution,
(d) the precipitant,
(e) the first hydrofluoric acid doping element solution,
where, in the case of the doping element being present in dissolved form in the doping element solution or in the precipitant or in both, the doping element solution or the precipitant or both is/are added to the first hydrofluoric acid solution, the second hydrofluoric acid solution, the hydrofluoric acid mixed solution or the alternative hydrofluoric acid mixed solution so that the doping element is at least partially precipitated as oxide or hydroxide during the precipitation.

6. Process according to Claim 5, **characterized in that** the basic solution contains a first alkali metal hydroxide solution or a first alkaline earth metal hydroxide solution, or both, or a first mixture of a plurality of alkali metal hydroxide solutions or a first mixture of a plurality of alkaline earth metal hydroxide solutions, or both, or a first mixture of one or more alkali metal hydroxide solutions or a first mixture, or both, of one or more alkaline earth metal hydroxide solutions, where the alkali metal hydroxide or alkaline earth metal hydroxide solutions, or both, comprise at least one dissolved amphoteric element,
where the first alkali metal hydroxide solution comprises a first alkali element and the first alkaline earth metal hydroxide solution comprises a first alkaline earth element and the first mixture of a plurality of alkali metal hydroxide solutions comprises a plurality of alkali elements and the first mixture of a plurality of alkaline earth metal hydroxide solutions comprises a plurality of alkaline earth elements, so that a first suspension containing a first intermediate which comprises, in the solid component, a first alkali element or a mixture of a plurality of alkali elements or a first alkaline earth element, or both, or a mixture of alkaline earth elements in uniformly distributed form is obtained.

7. Process according to Claim 6, wherein the first alkali metal hydroxide solution or the first alkaline earth metal hydroxide solution, or both, comprise(es) an aqueous hydroxide or a hydroxide complex or aqueous hydroxide and hydroxide complex.

8. Process according to Claim 7, wherein the aqueous hydroxide comprises at least one alkali metal hydroxide selected from the group consisting of KOH, LiOH, NaOH, RbOH, Ca(OH)₂, and at least one hydroxide complex of the elements selected from the group consisting of zinc, aluminium, antimony, tin.

9. Process according to any of the preceding claims, **characterized in that** the suspension is filtered so that the solid state mixture is present as a suspension residue.

10. Process according to Claim 8, **characterized in that** the suspension residue is washed.

11. Process according to any of the preceding claims, **characterized in that** the suspension or the suspension residue is dried so as to give a dried residue.

12. Process according to any of the preceding claims, **characterized in that** the suspension or the suspension residue is mixed.

13. Process according to any of the preceding claims, **characterized in that** a basic solution having an aqueous or organic basis is added to the suspension, the suspension residue, the dried residue, the mixed suspension residue or the mixed suspension so as to give a first intermediate.

14. Process according to Claim 10, **characterized in that** the addition of the basic solution is carried out with stirring.

15. Process according to Claim 13 or 14, **characterized in that** the basic solution comprises an alkali metal hydroxide solution and/or an alkaline earth metal hydroxide solution or a mixture of a plurality of alkali metal hydroxide solutions and/or a mixture of a plurality of alkaline earth metal hydroxide solutions, where the alkali metal hydroxide solution comprises an alkali element and the alkaline earth metal hydroxide solution comprises an alkaline earth element and the mixture of a plurality of alkali metal hydroxide solutions comprises a plurality of alkali elements and the mixture of a plurality of alkaline earth metal hydroxide mixtures comprises a plurality of alkaline earth elements, so that a second intermediate which comprises an alkali element or a mixture of a plurality of alkali elements or an alkaline earth element or a mixture of alkaline earth elements in uniformly distributed form is obtained.

16. Process according to any of Claims 13 to 15, **characterized in that** the addition of the basic solution is carried out at temperatures in the range from 0°C to 40°C, in particular at room temperature, and a pressure in the range from 800 mbar to 1200 mbar, in particular under atmospheric pressure.

17. Process according to any of Claims 6 to 16, **characterized in that** the first or second intermediate is heat treated at a temperature in the range from 100°C to 1000°C, in particular from 400°C to 700°C, so as to form a ceramic material and a by-product.

18. Process according to Claim 17, **characterized in that** the by-product is washed out by means of water.

19. Process according to Claim 18, **characterized in that** the ceramic material is dried and/or milled so as to give a homogeneous ceramic powder for ceramic shaping.

20. Process according to Claim 19, **characterized in that** an auxiliary for controlling particle agglomeration during milling and/or during drying is added.

21. Process according to any of the preceding claims, **characterized in that** process products formed are dried, slurried, filtered off and/or comminuted.

22. Ceramic material, in particular in the form of powders or pastes, **characterized in that** the ceramic material is obtained by a process according to any of Claims 1 to 21.

23. Process for producing a shaped body, **characterized in that** the shaped body is obtained from the ceramic material according to Claim 22 by uniaxial or cold isostatic pressing, tape casting with optional subsequent stacking and/or screen printing of green contact layers, PIM (powder injection moulding), wet powder spraying, slip casting or sintering.

24. Process according to Claim 23, **characterized in that** a metallic contact is attached to the shaped body, in particular during sintering.

25. Process according to Claim 24, **characterized in that** the metallic contact comprises an Ag-Pd alloy having a Pd content of ≤ 25%, preferably ≤ 15%, particularly preferably ≤ 7.5%.

26. Process according to Claim 24, **characterized in that** the metallic contact comprises an Ag alloy which is free of Pd.

27. Use of a shaped body obtainable by a process according to any of Claims 23 to 26 for producing a composite, in particular a piezoelectric element as is used in removal metres, ultrasonic transducers, ink jet nozzles, common-rail diesel injectors.

## Revendications

1. Procédé de fabrication d'un système homogène à plusieurs composants à base d'hydroxyde et/ou d'oxyde, notamment d'un système homogène à plusieurs composants ayant une morphologie en forme de bâtonnet, le système à plusieurs composants comprenant un premier élément du groupe constitué par Mo, W, Nb, Re, Zr, Hf, V, Sb, Si, Al et Ta, et un deuxième élément du groupe constitué par Mo, W, Nb, Re, Zr, Hf, V, Sb, Si, Al et Ta, et le premier élément et le deuxième élément étant différents, le premier ou le deuxième élément ou le premier et le deuxième élément se présentant sous la forme d'un complexe de fluor ou d'oxyfluor ou sous la forme d'un complexe de fluor et d'oxyfluor ; selon la première alternative, le premier élément se présentant dans une première solution d'acide fluorhydrique et le deuxième élément dans une deuxième solution d'acide fluorhydrique, et la première solution fluorhydrique contenant le premier élément et la deuxième solution fluorhydrique contenant le deuxième élément étant mélangées, de telle sorte qu'une solution mélangée d'acide fluorhydrique contenant le premier et le deuxième élément dissous soit présente,
ou
selon une deuxième alternative, le premier élément et le deuxième élément étant dissous dans une solution mélangée d'acide fluorhydrique alternative,
et enfin,
la solution mélangée d'acide fluorhydrique ou la solution mélangée d'acide fluorhydrique alternative étant précipitée avec un agent de précipitation, de telle sorte qu'un mélange de solides dans une suspension soit présent, l'agent de précipitation étant une solution basique, un solide à effet basique ou un gaz à effet basique, et la précipitation ayant lieu à un pH compris entre 6,5 et 14 de la solution mélangée d'acide fluorhydrique ou de la solution mélangée d'acide fluorhydrique alternative.

2. Procédé selon la revendication 1, **caractérisé en ce que** le premier ou le deuxième élément ou le premier et le deuxième élément se présentent sous la forme d'H₂NbF₇, H₂TaF₇, HSbF₆, H₂ZrF₆, H₂SiF₆, H₃AlF₆.

3. Procédé selon la revendication 1 ou 2, **caractérisé en ce qu'**une troisième solution d'acide fluorhydrique ou plus contenant un troisième élément dissous ou plus du groupe constitué par Mo, W, Nb, Re, Zr, Hf, V et Ta est incorporée dans la solution mélangée d'acide fluorhydrique ou la solution mélangée d'acide fluorhydrique alternative avant la précipitation.

4. Procédé selon l'une quelconque des revendications précédentes, **caractérisé en ce qu'**un troisième élément ou plus du groupe constitué par Mo, W, Nb, Re, Zr, Hf, V et Ta est dissous dans la solution mélangée d'acide fluorhydrique ou la solution mélangée d'acide fluorhydrique alternative avant la précipitation.

5. Procédé selon l'une quelconque des revendications précédentes, **caractérisé en ce qu'**un élément dopant du groupe constitué par Ti, Zr, Sn, Fe, Co, Ni, Ca, Zn, Pd, Cd, Al, Si, P, Ge, As, Se, Sb, Te, Sc, Y, Yb est dissous dans au moins une solution, choisie dans le groupe constitué par :
(a) la première solution d'acide fluorhydrique,
(b) la deuxième solution d'acide fluorhydrique,
(c) la solution mélangée d'acide fluorhydrique alternative,
(d) l'agent de précipitation,
(e) la première solution d'élément dopant dans de l'acide fluorhydrique,
lorsque l'élément dopant est dissous dans la solution d'élément dopant ou dans l'agent de précipitation ou dans les deux, la solution d'élément dopant ou l'agent de précipitation ou les deux étant ajoutés à la première solution d'acide fluorhydrique, à la deuxième solution d'acide fluorhydrique, à la solution mélangée d'acide fluorhydrique ou à la solution mélangée d'acide fluorhydrique alternative, de telle sorte que l'élément dopant précipite au moins en partie sous la forme d'un oxyde ou d'un hydroxyde lors de la précipitation.

6. Procédé selon la revendication 5, **caractérisé en ce que** la solution basique contient une première solution d'hydroxyde alcalin ou une première solution d'hydroxyde alcalino-terreux ou les deux, ou un premier mélange de plusieurs solutions d'hydroxyde alcalin ou un premier mélange de plusieurs solutions d'hydroxyde alcalino-terreux ou les deux, ou un premier mélange d'une ou de plusieurs solutions d'hydroxyde alcalin, ou un premier mélange ou les deux d'une ou de plusieurs solutions d'hydroxyde alcalino-terreux, les solutions d'hydroxyde alcalin ou alcalino-terreux ou les deux comprenant au moins un élément amphotère dissous,
la première solution d'hydroxyde alcalin comprenant un premier élément alcalin et la première solution d'hydroxyde alcalino-terreux comprenant un premier élément alcalino-terreux et le premier mélange de plusieurs solutions d'hydroxyde alcalin comprenant plusieurs éléments alcalins et le premier mélange de plusieurs solutions d'hydroxyde alcalino-terreux comprenant plusieurs éléments alcalino-terreux, de manière à obtenir une première suspension contenant un premier produit intermédiaire, qui comprend dans la fraction solide un premier élément alcalin ou un mélange de plusieurs éléments alcalins, ou un premier élément alcalino-terreux ou les deux ou un mélange d'éléments alcalino-terreux répartis uniformément.

7. Procédé selon la revendication 6, dans lequel la première solution d'hydroxyde alcalin ou la première solution d'hydroxyde alcalino-terreux ou les deux comprennent un hydroxyde aqueux ou un complexe d'hydrogène ou un hydroxyde aqueux et un complexe d'hydroxyde.

8. Procédé selon la revendication 7, dans lequel l'hydroxyde aqueux comprend au moins un hydroxyde alcalin choisi dans le groupe constitué par KOH, LiOH, NaOH, RbOH, Ca(OH)₂, et au moins un complexe d'hydroxyde des éléments choisis dans le groupe constitué par le zinc, l'aluminium, l'antimoine, l'étain.

9. Procédé selon l'une quelconque des revendications précédentes, **caractérisé en ce que** la suspension est filtrée, de telle sorte que le mélange de solides se présente sous la forme d'un résidu de suspension.

10. Procédé selon la revendication 8, **caractérisé en ce que** le résidu de suspension est lavé.

11. Procédé selon l'une quelconque des revendications précédentes, **caractérisé en ce que** la suspension ou le résidu de suspension est séché, de telle sorte qu'un résidu séché soit présent.

12. Procédé selon l'une quelconque des revendications précédentes, **caractérisé en ce que** la suspension ou le résidu de suspension est mélangé.

13. Procédé selon l'une quelconque des revendications précédentes, **caractérisé en ce qu'**une solution basique aqueuse ou organique est ajoutée à la suspension, au résidu de suspension, au résidu séché, au résidu de suspension mélangé ou à la suspension mélangée, de manière à obtenir un premier produit intermédiaire.

14. Procédé selon la revendication 10, **caractérisé en ce que** l'ajout de la solution basique a lieu sous agitation.

15. Procédé selon la revendication 13 ou 14, **caractérisé en ce que** la solution basique comprend une solution d'hydroxyde alcalin et/ou une solution d'hydroxyde alcalino-terreux ou un mélange de plusieurs solutions d'hydroxyde alcalin et/ou un mélange de plusieurs solutions d'hydroxyde alcalino-terreux, la solution d'hydroxyde alcalin comprenant un élément alcalin et la solution d'hydroxyde alcalino-terreux comprenant un élément alcalino-terreux et le mélange de plusieurs solutions d'hydroxyde alcalin comprenant plusieurs éléments alcalins et le mélange de plusieurs mélanges d'hydroxyde alcalino-terreux comprenant plusieurs éléments alcalino-terreux, de manière à obtenir un deuxième produit intermédiaire qui comprend un élément alcalin ou un mélange de plusieurs éléments alcalins ou un élément alcalino-terreux ou un mélange d'éléments alcalino-terreux répartis uniformément.

16. Procédé selon l'une quelconque des revendications 13 à 15, **caractérisé en ce que** l'ajout de la solution basique a lieu à des températures comprises entre 0 °C et 40 °C, notamment à température ambiante, et à une pression comprise entre 800 mbar et 1 200 mbar, notamment à pression normale.

17. Procédé selon l'une quelconque des revendications 6 à 16 précédentes, **caractérisé en ce que** le premier ou le deuxième produit intermédiaire est traité thermiquement à une température comprise entre 100 °C et 1 000 °C, notamment entre 400 °C et 700 °C, de manière à former un matériau céramique et un produit secondaire.

18. Procédé selon la revendication 17, **caractérisé en ce que** le produit secondaire est lavé avec de l'eau.

19. Procédé selon la revendication 18, **caractérisé en ce que** le matériau céramique est séché et/ou broyé, de telle sorte qu'une poudre céramique homogène pour un façonnage céramique soit présente.

20. Procédé selon la revendication 19, **caractérisé en ce qu'**un adjuvant pour l'ajustement d'une agglomération des particules est ajouté lors du broyage et/ou lors du séchage.

21. Procédé selon l'une quelconque des revendications précédentes, **caractérisé en ce que** les produits de procédé formés sont séchés, mis en suspension, filtrés et/ou broyés.

22. Matériau céramique, notamment sous la forme de poudres ou de pâtes, **caractérisé en ce que** le matériau céramique est obtenu par un procédé selon l'une quelconque des revendications 1 à 21.

23. Procédé de fabrication d'un corps moulé, **caractérisé en ce que** le corps moulé est obtenu à partir du matériau céramique selon la revendication 22 par compression uniaxiale ou isostatique à froid, coulée de feuilles avec éventuellement empilement ultérieur et/ou sérigraphie de couches de contact vertes, PIM (Power Injection Moulding), injection de poudre humide, coulée en barbotine ou frittage.

24. Procédé selon la revendication 23, **caractérisé en ce qu'**un contact métallique est appliqué sur le corps moulé, notamment lors du frittage.

25. Procédé selon la revendication 24, **caractérisé en ce que** le contact métallique comprend un alliage d'Ag-Pd ayant une teneur en Pd ≤ 25 %, de préférence ≤ 15 %, de manière particulièrement préférée ≤ 7,5 %.

26. Procédé selon la revendication 24, **caractérisé en ce que** le contact métallique comprend un alliage d'Ag qui est exempt de Pd.

27. Utilisation d'un corps moulé pouvant être obtenu par un procédé selon les revendications 23 à 26 pour la fabrication d'un corps composite, notamment d'un élément piézoélectrique tel qu'utilisé dans des télémètres, des transducteurs ultrasoniques, des buses à jet d'encre, des injecteurs diesel à rampe commune.
